# EUROPEAN PATENT SPECIFICATION

(11) **EP 4 620 605 B1**
(45) Date of publication and mention of the grant of the patent: **25.02.2026**
(21) Application number: 24165131.4
(22) Date of filing: 21.03.2024
(51) Int. Cl.: B23K 1/002, B23K 1/008, B23K 3/047

(54) **METHOD AND ARRANGEMENT FOR CONNECTING ELEMENTS TO A SUBSTRATE**
VERFAHREN UND ANORDNUNG ZUM VERBINDEN VON ELEMENTEN MIT EINEM SUBSTRAT
PROCÉDÉ ET AGENCEMENT POUR RELIER DES ÉLÉMENTS À UN SUBSTRAT

(43) Date of publication of application: 24.09.2025
(73) Proprietor: Infineon Technologies AG, 85579 Neubiberg (DE)
(72) Inventor: DENKER, Lukas, 33098 Paderborn (DE); BLECHER, Oliver, 42289 Wuppertal (DE)
(74) Representative: Westphal, Mussgnug & Partner, Patentanwälte mbB

(56) References cited:
- US-A1- 2002 139 794
- US-A1- 2012 248 094
- US-A1- 2017 203 377

## Description

The instant disclosure relates to a method and an arrangement for connecting elements to a substrate, in particular to a substrate for a semiconductor module, see claims 1 and 9.

### BACKGROUND

Document US 2002/139794 A1 (describing the preamble of claims 1 and 9) shows an apparatus for controlled-atmosphere brazing of parts or components having cross-sectional dimensions of up to twenty-four inches. The apparatus maintains the components or parts at a uniform temperature during the brazing cycle. The apparatus comprises a susceptor having a physical boundary that separates an interior of the susceptor from its exterior. While there is no limitation upon the length of the parts that or components that can be brazed, the wall of the susceptor formed as a physical boundary has an internal diameter that limits the maximum cross-sectional dimension of the parts or components that are to be brazed, so that the parts or components reside within the interior of the susceptor. A means for heating the susceptor is provided. The heating source is capable of heating the susceptor sufficiently so that the interior of the susceptor can reach a temperature sufficient to braze the components inside the susceptor. The susceptor containing the parts to be brazed and heating source are placed within a chamber that can provide a desired protective environment, such as a vacuum, an inert gas atmosphere, a reducing gas or nitrogen. The susceptor conducts and radiates the heat across its physical boundary so that a uniform temperature is attained and maintained within the interior of the susceptor during the brazing cycle. The susceptor is desirably comprised of graphite or a refractory metal.

Document US 2017/203377 A1 discloses a heating and cooling device including: an airtight processing chamber openable to load a member-to-be-processed in the airtight processing chamber; a transfer apparatus to adjust a distance between the member-to-be-processed and a cooling unit that cools the member-to-be-processed, by moving the member-to-be-processed and/or the cooling unit; an induction heating apparatus to heat the member-to-be-processed, including an induction heating coil; a cooling apparatus to cool the member-to-be-processed by cooling the cooling unit; a temperature sensor to determine a temperature of the member-to-be-processed; and a controller to control the induction heating apparatus and the cooling apparatus based on the temperature determined by the temperature sensor.

Power semiconductor module arrangements often include at least one substrate. A semiconductor arrangement including a plurality of controllable semiconductor elements (e.g., two IGBTs in a half-bridge configuration) or non-controllable semiconductor elements (e.g., arrangements of diodes) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate.

Controllable or non-controllable semiconductor elements are often coupled to the substrate or to other components of the power semiconductor module arrangement by means of soldered connections. In order to form a soldered connection, a layer of soldering paste is usually arranged between the substrate and a semiconductor element that is to be attached to the substrate. Soldering pastes typically comprise metallic components as well as organic/volatile components (e.g., flux agents). During the soldering process (usually performed under the influence of heat and pressure), volatile components evaporate and are no longer present in the resulting soldered connection after the soldering process has been completed. Soldering processes are generally performed in a process chamber. Any volatile components evaporating from the solder paste spread within the process chamber during the soldering process and may settle (condense) on surfaces of or within the process chamber. A contamination caused by condensed volatile components of the soldering layer may be acceptable on some surfaces. If, however, the soldering process is performed in a vacuum induction chamber, and the condensate settles on the inductor coils, this may negatively influence any subsequent soldering processes performed in the same process chamber.

There is a need for a method and an arrangement for connecting elements to a substrate in a swift, reliable, cost-effective and space saving way.

### SUMMARY

According to a first aspect of the present invention, an arrangement is defined in claim 1, wherein the arrangement includes a process chamber, an inductor chamber with one or more inductors arranged therein, a supply tube configured to carry process gas from a gas source to the process chamber, an outlet tube configured to carry process gas away from the process chamber, a first bypass tube arranged between the supply tube and the inductor chamber, and configured to carry process gas from the supply tube to the inductor chamber, and a second bypass tube arranged between the inductor chamber and the outlet tube, and configured to carry process gas from the inductor chamber to the outlet tube, wherein a wall separates the inductor chamber from the process chamber.

According to a second aspect of the present invention, a method is defined in claim 9, wherein the method includes arranging one or more first connection partners on a carrier, wherein each of the one or more first connection partners has one or more second connection partners arranged thereon, and wherein a solder layer is arranged between each of the one or more second connection partners and the respective first connection partner, arranging the carrier with the one or more first connection partners arranged thereon in the process chamber of an arrangement according to the first aspect of the present invention, inserting process gas into the supply tube, thereby filling the process chamber and the inductor chamber with process gas, and inductively heating the one or more first connection partners with the one or more solder layers and second connection partners arranged thereon by means of the one or more inductors.

Preferred embodiments of the first and second aspects of the present invention are defined in their respective dependent claims.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a substrate for a power semiconductor module arrangement.
Figure 2 is a cross-sectional view of an arrangement for connecting elements to a substrate according to embodiments of the disclosure.
Figure 3 is a cross-sectional view of an arrangement for connecting elements to a substrate according to further embodiments of the disclosure.
Figure 4 is a cross-sectional view of an arrangement for connecting elements to a substrate according to even further embodiments of the disclosure.
Figure 5, in a flow diagram, schematically illustrates a method for connecting elements to a substrate according to embodiments of the disclosure.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

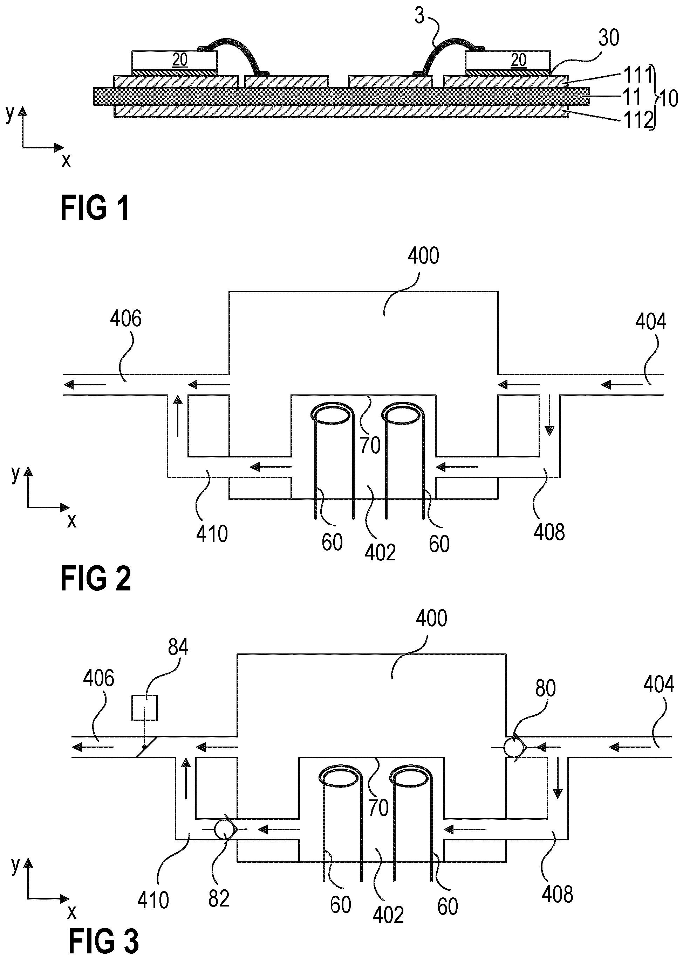

Referring to Figure 1, a cross-sectional view of a substrate 10 for a power semiconductor module arrangement is schematically illustrated. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin. The substrate 10 may be arranged in or form a ground surface of a housing, for example (housing not specifically illustrated in Figure 1).

One or more semiconductor bodies 20 may be arranged on the substrate 10. Each of the semiconductor bodies 20 arranged on the substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable (active) or non-controllable (passive) element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes four different sections. Different semiconductor bodies 20 may be mounted to the same or to different sections of the first metallization layer 111. Different sections of the first metallization layer may have no electrical connection or may be electrically connected to one or more other sections using, e.g., bonding wires 3. Electrical connections 3 may also include connection plates or conductor rails, for example, to name just a few examples. The one or more semiconductor bodies 20 may be electrically and mechanically connected to the substrate 10 by an electrically conductive connection layer 30. Such an electrically conductive connection layer may be a solder layer, for example.

When connecting an active or passive element to the substrate 10, a pre-layer may be formed on a surface of the substrate 10 (e.g., on the first metallization layer 111) or on a surface of the active or passive element, for example. The pre-layer is generally formed by applying a soldering paste to the respective surface. Soldering pastes typically comprise metallic components as well as organic/volatile components (e.g., flux agents). During the soldering process (usually performed under the influence of heat and pressure), volatile components evaporate from the pre-layer and are no longer present in the resulting soldering layer after the soldering process has been completed. Soldering processes are generally performed in a process chamber. Any volatile components evaporating from the pre-layer spread within the process chamber during the soldering process and may settle (condense) on surfaces of (e.g., sidewalls, bottom, etc.) or within the process chamber (e.g., surfaces of any elements arranged within the process chamber). A contamination caused by condensed volatile components of the soldering layer may be acceptable on some surfaces. If, however, the soldering process is performed in a vacuum induction chamber, and the condensate settles on the inductor coils, this may negatively influence any subsequent soldering processes performed in the same process chamber. Contaminants settling on the inductor coils, for example, may lead to short circuits in the coils or block the magnetic fields generated by the inductors, thereby reducing the efficiency of the process.

When using conventional vacuum chambers comprising heating plates instead of inductor coils, a contamination caused by condensed volatile components of the soldering layer is generally noncritical. Vacuum induction chambers, however, have several advantages over vacuum chambers comprising heating plates. For example, a lower temperature variation among multiple substrates 10 within an induction chamber results in higher yields. Further, introducing heat by means of induction instead of heating plates allows for a greater range of dynamically selectable temperatures and heating gradients. Even further, the concerned components heat up much faster when using induction which results in a shorter cycle time and, therefore, a higher production capacity.

Now referring to Figure 2, an arrangement for connecting elements to a substrate according to embodiments of the disclosure is schematically illustrated. The arrangement comprises a process chamber 400 and an inductor chamber 402 with one or more inductors 60 arranged therein. The process chamber 400 is the chamber in which the actual soldering process is performed. That is, during a soldering process, one or more substrates 10 are arranged in the process chamber 400, wherein each of the one or more substrates 10 has one or more elements (e.g., active or passive components) arranged thereon, with a solder layer 30 arranged between each of the one or more elements and the respective substrate 10. A wall 70 separates the inductor chamber 402 from the process chamber 400. This is, because during a soldering process, volatile components (e.g., flux agents) evaporate from the solder layers 30. The wall 70 prevents the volatile components from depositing on the one or more inductors 60 arranged in the inductor chamber 402.

The arrangement further comprises a supply tube 404 configured to carry process gas from a gas source (not specifically illustrated) to the process chamber 400, and an outlet tube 406 configured to carry process gas away from the process chamber 400. A process gas is usually required in the process chamber 400 during the soldering process. A soldering process, however, is generally performed under pressure. This pressure may be an atmospheric pressure (roughly 1000mbar), underpressured as low as 1 mbar, or overpressured as high as 5000 mbar. The result may be a great difference in pressure between the process and induction chambers. Thus, the walls of the process chamber 400 need to withstand high compressive forces, and, therefore, generally need to have a certain minimum thickness in order to be able to withstand these high compressive forces. A thick wall 70 between the process chamber 400 and the inductor chamber 402, however, creates an undesirably large distance between a carrier and/or substrate 10 in the process chamber 400 and the one or more inductors 60, greatly diminishing the efficiency of the induction process. Therefore, the arrangement further comprises a first bypass tube 408 arranged between the supply tube 404 and the inductor chamber 402, and configured to carry process gas from the supply tube 404 to the inductor chamber 402, and a second bypass tube 410 arranged between the inductor chamber 402 and the outlet tube 406, and configured to carry process gas from the inductor chamber 402 to the outlet tube 406. That is, process gas is not only filled into the process chamber 400, but also simultaneously into the inductor chamber 402. As the process gas is provided from the same gas source and through the same inlet, a pressure inside the inductor chamber 402 equals a pressure inside the process chamber 400 during the soldering process. Therefore, no or very low compressive forces are exerted on the wall 70 separating the inductor chamber 402 from the process chamber 400. Likewise, after soldering, the process chamber 400 and the inductor chamber 402 can also be evacuated simultaneously, maintaining roughly equal pressure in both chambers so as to minimize forces exerted on wall 70.

The bypass tubes branching off the supply tube 404 and the outlet tube 406 allow for a pressure compensation between the inductor chamber 402 and the process chamber 400. The wall 70 separating the inductor chamber 402 from the process chamber 400, therefore, may be a thin wall, as it does not need to withstand high forces. According to one example, the wall 70 separating the inductor chamber 402 from the process chamber 400 has a thickness of between 0.5 and 5 millimeters. Magnetic fields generated by the one or more inductors 60 can easily penetrate such a thin wall 70. The wall 70 separating the inductor chamber 402 from the process chamber 400 may consist of a non-conductive material. According to one example, the wall 70 separating the inductor chamber 402 from the process chamber 400 consists of a glass ceramic. Glass ceramic is a material that is generally used for induction cookers, for example, as the magnetic fields may easily penetrate through such material. Any other suitable materials, however, can also be used instead. A distance between the one or more inductors 60 arranged in the inductor chamber 402 and the wall 70 separating the inductor chamber 402 from the process chamber 400 may be small, e.g., less than 10 millimeters, and is preferably as small as feasible. A distance of less than 1 mm would be optimal.

The arrangement may further comprise a first valve 80 arranged in the supply tube 404 between the process chamber 400 and an inlet of the first bypass tube 408. The first valve 80 may be configured to allow process gas to flow from the supply tube 404 to the process chamber 400, and to prevent process gas from flowing from the process chamber 400 back into the supply tube 404. In this way, process gas contaminated with flux agents or other contaminants may be prevented from entering the supply tube 404 and, especially, the first bypass tube 408 and the inductor chamber 402. An arrangement comprising a first valve 80 is schematically illustrated in Figure 3, for example.

Still referring to Figure 3, the arrangement may further comprise a second valve 82 arranged in the second bypass tube 410. The second valve 82, similar to the first valve 80, may be configured to allow process gas to flow from the inductor chamber 402 to the second bypass tube 410 and further to the outlet tube 406, and to prevent process gas from flowing from the outlet tube 406 through the second bypass tube 410 back towards the inductor chamber 402. In this way, contaminated process gas flowing from the process chamber 400 though the outlet tube 406 may be prevented from flowing into the inductor chamber 402. That is, by means of a first and/or second valve 80, 82, a contamination of the one or more inductors 60 arranged in the inductor chamber 402 may be effectively prevented.

The arrangement may further comprise an evacuation valve 84 arranged in the outlet tube 406 between an outlet of the second bypass tube 410 and an outlet of the outlet tube 406, and configured to remove process gas from the process chamber 400 and the inductor chamber 402. That is, the evacuation valve 84 may be configured to actively suck process gas from the process chamber 400 and the inductor chamber 402. The outlet of the second bypass tube 410 is the end of the second bypass tube 410 which is connected to the outlet tube 406 and where process gas flows from the second bypass tube 410 into the outlet tube 406. An inlet of the first bypass tube 408 similarly is an end of the first bypass tube 408 connected to the supply tube 404, where process gas flows from the supply tube 404 into the first bypass tube 408. The outlet of the outlet tube 406 is an end of the outlet tube 406 where process gas flows out of the outlet tube 406. An inlet of the outlet tube 406 is connected to the process chamber 400 such that process gas can flow from the process chamber 400 into the outlet tube 406. Similarly, an inlet of the supply tube 404 is an end of the supply tube which may be connected to a gas source such that gas can flow from the gas source into the supply tube 404, and an outlet of the supply tube 404 is connected to the process chamber 400 such that process gas can flow from the supply tube 404 into the process chamber 400.

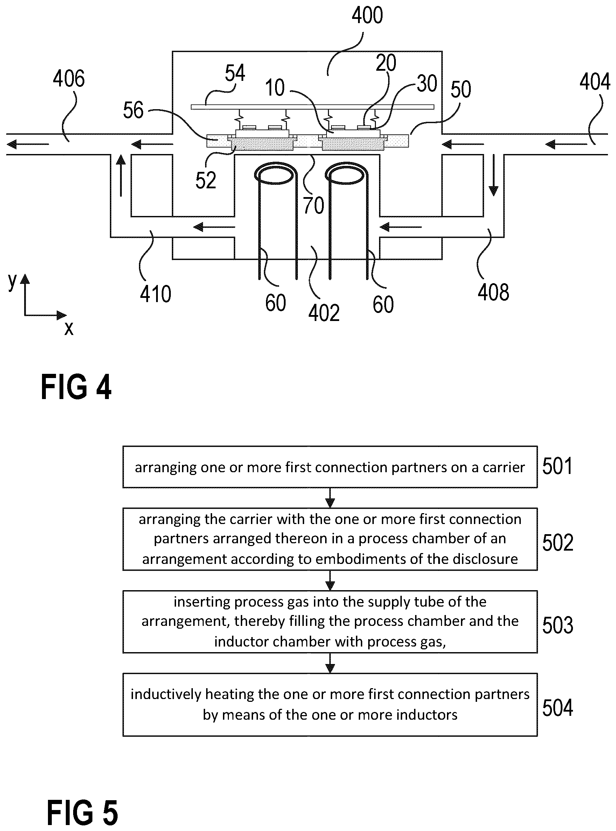

When a soldering process is performed in the process chamber, any substrates 10 that are to be equipped with elements (e.g., active or passive components) may be arranged on at least one plate 52 supported by a carrier 50, as is schematically illustrated in Figure 4. The at least one plate 52 may consist of or comprise a metallic material such that it is heated when it is exposed to the magnetic field generated by the one or more inductors 60. The heat generated by means of the at least one plate 52 is then transferred to the substrates 10 arranged thereon. A solder layer 30 arranged between a substrate 10 and an element that is to be attached thereto will consequently also be heated. In this way, a solder paste forming the solder layer 30 is heated. When the solder layer 30 subsequently cools down again, a permanent connection between the element and the substrate 10 is formed. A carrier 50, during the soldering process, may be arranged close to the wall 70 separating the process chamber 400 from the inductor chamber 402, such that the at least one metallic plate 52 is penetrated by the magnetic field generated by the one or more inductors 60. The carrier 50 and the at least one plate 52 are generally separate external components and are not part of the arrangement itself.

According to one example (see Figure 4), the carrier 50 comprises a frame 56, and the at least one metallic plate 52 is suspended within the frame 56. In this embodiment, the space between the at least one metallic plate 52 and the inductors 60 is minimized as they will be separated only by the thin wall 70. One or more substrates 10 may be arranged directly on each of the one or more metallic plates 52. In this way, heat may be transferred directly from a metallic plate 52 to the respective one or more substrates 10. The one or more substrates 10 may be pressed onto the at least one metallic plate 52 by means of a downholder arrangement 54, for example. In this way, a good contact between the substrates 10 and the metallic plates 52 may be achieved which increases the heat transfer between the metallic plates 52 and the substrates 10. A downholder arrangement 54, however, generally is optional. It is also contemplated that the metallic plates 52 could be embedded in the carrier 50 with an exposed upper surface, or that the metallic plates 52 might be fixed to a planar surface of a thin tray-like carrier 50. Alternatively, metallic plates 52 could also be eliminated entirely, such that the one or more substrates 10 are supported directly by the carrier 50 and heated directly by inductors 60.

The arrangement according to embodiments of the disclosure may be used to connect elements to a substrate 10 by means of solder layers. Generally, however, the arrangement may be used to connect any connection partners to each other by means of solder layers.

A method according to embodiments of the disclosure, as is exemplarily illustrated in Figure 5, comprises arranging one or more first connection partners on a carrier 50 (step 501), wherein each of the one or more first connection partners has one or more second connection partners arranged thereon, and wherein a solder layer 30 is arranged between each of the one or more second connection partners and the respective first connection partner. The method further comprises arranging the carrier 50 with the one or more first connection partners arranged thereon in the process chamber 400 of the arrangement as described above (step 502), inserting process gas into the supply tube 404, thereby filling the process chamber 400 and the inductor chamber 402 with process gas (step 503), and inductively heating the one or more first connection partners with the one or more solder layers 30 and second connection partners arranged thereon by means of the one or more inductors 60 (step 504).

The method may further comprise removing the process gas from the process chamber 400 and the inductor chamber 402 through the outlet tube 406, and removing the carrier 50 from the process chamber 400. According to one example, inductively heating the one or more first connection partners with the one or more solder layers 30 and second connection partners arranged thereon by means of the one or more inductors 60 comprises applying an alternating current to each of the one or more inductors 60, thereby generating an alternating magnetic field, wherein the carrier 50 is arranged in the alternating magnetic field. According to one example, the carrier 50 supports at least one metallic plate 52, and inductively heating the one or more first connection partners with the one or more solder layers 30 and second connection partners arranged thereon by means of the one or more inductors 60 further comprises inducing electromagnetic currents in the one or more metallic plates 52, thereby heating the one or more metallic plates 52.

The arrangements according to the various embodiments described above allow to inductively solder second connection partners (e.g., active of passive semiconductor elements) to first connection partners (e.g., substrates 10) by means of solder layers 30 formed by solder paste without contaminating the inductors 60 that are used to inductively heat the first connection partners as well as the solder layers 30 and second connection partners arranged thereon. No elaborate design is required in order to provide a pressure compensation between the process chamber 400 and the inductor chamber 402, which is solely separated from the process chamber 400 by means of a wall 70. A pressure compensation is achieved automatically by coupling the inductor chamber 402 to the supply tube 404 and the outlet tube 406 by means of first and second bypass tubes 408, 410. The risk of a failure of the arrangement is very low as compared to a system that actively regulates a pressure inside the inductor chamber 402 to match the pressure of the process chamber 400, for example.

## Claims

1. An arrangement comprises:
a process chamber (400);
the arrangement being **characterised by** the following:
an inductor chamber (402) with one or more inductors (60) arranged therein;
a supply tube (404) configured to carry process gas from a gas source to the process chamber (400);
an outlet tube (406) configured to carry process gas away from the process chamber (400);
a first bypass tube (408) arranged between the supply tube (404) and the inductor chamber (402), and configured to carry process gas from the supply tube (404) to the inductor chamber (402); and
a second bypass tube (410) arranged between the inductor chamber (402) and the outlet tube (406), and configured to carry process gas from the inductor chamber (402) to the outlet tube (406), wherein
a wall (70) separates the inductor chamber (402) from the process chamber (400).

2. The arrangement of claim 1, wherein the wall (70) separating the inductor chamber (402) from the process chamber (400) has a thickness of between 0.5 and 5 millimeters.

3. The arrangement of claim 1 or 2, wherein the wall (70) separating the inductor chamber (402) from the process chamber (400) consists of a non-conductive material.

4. The arrangement of claim 3, wherein the wall (70) separating the inductor chamber (402) from the process chamber (400) consists of glass ceramic.

5. The arrangement of any of the preceding claims, further comprising a first valve (80) arranged in the supply tube (404) between the process chamber (400) and an inlet of the first bypass tube (408), wherein the first valve (80) is configured to allow process gas to flow from the supply tube (404) into the process chamber (400), and to prevent process gas from flowing from the process chamber (400) back into the bypass tube (408).

6. The arrangement of any of the preceding claims, further comprising a second valve (82) arranged in the second bypass tube (410), wherein the second valve (82) is configured to allow process gas to flow from the inductor chamber (402) to the second bypass tube (410), and to prevent process gas from flowing from the second bypass tube (410) back towards the inductor chamber (402).

7. The arrangement of any of the preceding claims, further comprising an evacuation valve (84) arranged in the outlet tube (406) between an outlet of the second bypass tube (410) and an outlet of the outlet tube (406), and configured to remove process gas from the process chamber (400) and the inductor chamber (402).

8. The arrangement of any of the preceding claims, wherein a distance between the one or more inductors (60) arranged in the inductor chamber (402) and the wall (70) separating the inductor chamber (402) from the process chamber (400) is less than 10 millimeters.

9. A method comprising
arranging one or more first connection partners on a carrier (50), wherein each of the one or more first connection partners has one or more second connection partners arranged thereon, and wherein a solder layer (30) is arranged between each of the one or more second connection partners and the respective first connection partner,
the method being **characterised by**:
arranging the carrier (50) with the one or more first connection partners arranged thereon in the process chamber (400) of the arrangement of any of claims 1 to 8,
inserting process gas into the supply tube (404), thereby filling the process chamber (400) and the inductor chamber (402) with process gas, and
inductively heating the one or more first connection partners with the one or more solder layers (30) and second connection partners arranged thereon by means of the one or more inductors (60).

10. The method of claim 9, further comprising
removing the process gas from the process chamber (400) and the inductor chamber (402) through the outlet tube (406), and
removing the carrier (50) from the process chamber (400).

11. The method of claim 9 or 10, wherein inductively heating the one or more first connection partners with the one or more solder layers (30) and second connection partners arranged thereon by means of the one or more inductors (60) comprises applying an alternating current to each of the one or more inductors (60), thereby generating an alternating magnetic field, wherein the carrier (50) is arranged in the alternating magnetic field.

12. The method of claim 11, wherein the carrier (50) supports at least one metallic plate (52), and inductively heating the one or more first connection partners with the one or more solder layers (30) and second connection partners arranged thereon by means of the one or more inductors (60) further comprises inducing electromagnetic currents in the one or more metallic plates (52), thereby heating the one or more metallic plates (52).

## Patentansprüche

1. Anordnung, umfassend:
eine Prozesskammer (400);
wobei die Anordnung durch Folgendes gekennzeichnet ist:
eine Induktorkammer (402) mit einem oder mehreren darin angeordneten Induktoren (60);
ein Zuleitungsrohr (404), das dazu ausgelegt ist, Prozessgas von einer Gasquelle zur Prozesskammer (400) zu führen;
ein Auslassrohr (406), das dazu ausgelegt ist, Prozessgas von der Prozesskammer (400) wegzuführen;
ein erstes Bypassrohr (408), das zwischen dem Zuleitungsrohr (404) und der Induktorkammer (402) angeordnet ist und dazu ausgelegt ist, Prozessgas vom Zuleitungsrohr (404) zur Induktorkammer (402) zu führen; und
ein zweites Bypassrohr (410), das zwischen der Induktorkammer (402) und dem Auslassrohr (406) angeordnet ist und dazu ausgelegt ist, Prozessgas von der Induktorkammer (402) zum Auslassrohr (406) zu führen,
wobei
eine Wand (70) die Induktorkammer (402) von der Prozesskammer (400) trennt.

2. Anordnung nach Anspruch 1, wobei die Wand (70), die die Induktorkammer (402) von der Prozesskammer (400) trennt, eine Dicke zwischen 0,5 und 5 Millimetern aufweist.

3. Anordnung nach Anspruch 1 oder 2, wobei die Wand (70), die die Induktorkammer (402) von der Prozesskammer (400) trennt, aus einem nichtleitenden Material besteht.

4. Anordnung nach Anspruch 3, wobei die Wand (70), die die Induktorkammer (402) von der Prozesskammer (400) trennt, aus Glaskeramik besteht.

5. Anordnung nach einem der vorhergehenden Ansprüche, ferner umfassend ein erstes Ventil (80), das im Zuleitungsrohr (404) zwischen der Prozesskammer (400) und einem Einlass des ersten Bypassrohrs (408) angeordnet ist, wobei das erste Ventil (80) dazu ausgelegt ist, Prozessgas aus dem Zuleitungsrohr (404) in die Prozesskammer (400) strömen zu lassen und zu verhindern, dass Prozessgas aus der Prozesskammer (400) zurück in das Bypassrohr (408) strömt.

6. Anordnung nach einem der vorhergehenden Ansprüche, ferner umfassend ein zweites Ventil (82), das im zweiten Bypassrohr (410) angeordnet ist, wobei das zweite Ventil (82) dazu ausgelegt ist, Prozessgas aus der Induktorkammer (402) in das zweite Bypassrohr (410) strömen zu lassen und zu verhindern, dass Prozessgas aus dem zweiten Bypassrohr (410) zurück in Richtung der Induktorkammer (402) strömt.

7. Anordnung nach einem der vorhergehenden Ansprüche, ferner umfassend ein Evakuierungsventil (84), das im Auslassrohr (406) zwischen einem Auslass des zweiten Bypassrohrs (410) und einem Auslass des Auslassrohrs (406) angeordnet ist und dazu ausgelegt ist, Prozessgas aus der Prozesskammer (400) und der Induktorkammer (402) zu entfernen.

8. Anordnung nach einem der vorhergehenden Ansprüche, wobei ein Abstand zwischen dem einen oder den mehreren Induktoren (60), die in der Induktorkammer (402) angeordnet sind, und der Wand (70), die die Induktorkammer (402) von der Prozesskammer (400) trennt, weniger als 10 Millimeter beträgt.

9. Verfahren, umfassend:
Anordnen eines oder mehrerer erster Verbindungspartner auf einem Träger (50), wobei jeder des einen oder der mehreren ersten Verbindungspartner einen oder mehrere darauf angeordnete zweite Verbindungspartner aufweist und wobei eine Lötschicht (30) zwischen jedem des einen oder der mehreren zweiten Verbindungspartner und dem jeweiligen ersten Verbindungspartner angeordnet ist,
wobei das Verfahren **gekennzeichnet ist durch**:
Anordnen des Trägers (50) mit dem einen oder den mehreren darauf angeordneten ersten Verbindungspartnern in der Prozesskammer (400) der Anordnung nach einem der Ansprüche 1 bis 8,
Einführen von Prozessgas in das Zuleitungsrohr (404), wodurch die Prozesskammer (400) und die Induktorkammer (402) mit Prozessgas gefüllt werden, und
induktives Erhitzen des einen oder der mehreren ersten Verbindungspartner mit der einen oder den mehreren Lotschichten (30) und darauf angeordneten zweiten Verbindungspartnern mittels des einen oder der mehreren Induktoren (60).

10. Verfahren nach Anspruch 9, ferner umfassend
Entfernen des Prozessgases aus der Prozesskammer (400) und der Induktorkammer (402) durch das Auslassrohr (406), und
Entfernen des Trägers (50) aus der Prozesskammer (400).

11. Verfahren nach Anspruch 9 oder 10, wobei das induktive Erhitzen des einen oder der mehreren ersten Verbindungspartner mit den daran angeordneten einen oder mehreren Lötmittelschichten (30) und den zweiten Verbindungspartnern mittels des einen oder der mehreren Induktoren (60) ein Anlegen eines Wechselstroms an jeden Induktor (60) umfasst, wodurch ein wechselndes Magnetfeld erzeugt wird, wobei der Träger (50) in dem wechselnden Magnetfeld angeordnet ist.

12. Verfahren nach Anspruch 11, wobei der Träger (50) mindestens eine Metallplatte (52) trägt und induktives Erhitzen des einen oder der mehreren ersten Verbindungspartner mit der einen oder den mehreren Lötschichten (30) und den darauf angeordneten zweiten Verbindungspartnern mittels des einen oder der mehreren Induktoren (60) ferner Induzieren elektromagnetischer Ströme in der einen oder den mehreren Metallplatten (52) umfasst, wodurch die eine oder die mehreren Metallplatten (52) erhitzt werden.

## Revendications

1. Un agencement comprend :
une chambre (400) de traitement ;
l'agencement étant **caractérisé par** ce qui suit :
une chambre (402) à inducteur ayant un ou plusieurs inducteurs (60) qui y sont disposés ;
un tube (404) d'alimentation configuré pour envoyer du gaz de traitement d'une source de gaz à la chambre (400) de traitement ;
un tube (406) de sortie configuré pour faire sortir du gaz de traitement de la chambre (400) de traitement ;
un premier tube (408) de dérivation disposé entre le tube (404) d'alimentation et la chambre (402) à inducteur et configuré pour envoyer du gaz de traitement du tube (404) d'alimentation à la chambre (402) à inducteur ; et
un deuxième tube (410) de dérivation disposé entre la chambre (402) à inducteur et le tube (406) de sortie et configuré pour envoyer du gaz de traitement de la chambre (402) à inducteur au tube (406) de sortie, dans lequel
une paroi (70) sépare la chambre (402) à inducteur de la chambre (400) de traitement.

2. L'agencement de la revendication 1, dans lequel la paroi (70) séparant la chambre (402) à inducteur de la chambre (400) de traitement a une épaisseur comprise entre 0,5 et 5 millimètres.

3. L'agencement de la revendication 1 ou 2, dans lequel la paroi (70) séparant la chambre (402) à inducteur de la chambre (400) de traitement consiste en un matériau non conducteur.

4. L'agencement de la revendication 3, dans lequel la paroi (70) séparant la chambre (402) à inducteur de la chambre (400) de pression consiste en de la vitrocéramique.

5. L'agencement de l'une quelconque des revendications précédentes, comprenant en outre une première soupape (80) montée dans le tube (404) d'alimentation entre la chambre (400) de traitement et l'entrée du premier tube (408) de dérivation, dans lequel la première soupape (80) est configurée pour permettre à du gaz de traitement de passer du tube (404) d'alimentation à la chambre (400) de traitement et pour empêcher du gaz de traitement de retourner de la chambre (400) de traitement au tube (408) de dérivation.

6. L'agencement de l'une quelconque des revendications précédentes, comprenant en outre une deuxième soupape (82) montée dans le deuxième tube (410) de dérivation, dans lequel la deuxième soupape (82) est configurée pour permettre à du gaz de traitement de passer de la chambre (402) à inducteur au deuxième tube (410) de dérivation et pour empêcher du gaz de traitement de retourner du deuxième tube (410) de dérivation à la chambre (402) à inducteur.

7. L'agencement de l'une quelconque des revendications précédentes, comprenant en outre une soupape (84) d'évacuation montée dans le tube (406) de sortie entre la sortie du deuxième tube (410) de dérivation et une sortie du tube (406) de sortie et configurée pour retirer du gaz de traitement de la chambre (400) de traitement et de la chambre (402) à inducteur.

8. L'agencement de l'une quelconque des revendications précédentes, dans lequel une distance entre le un ou les plusieurs inducteurs (60) disposés dans la chambre (402) à inducteur et la paroi (70) séparant la chambre (402) à inducteur et la chambre (400) de traitement est plus petite que 10 millimètres.

9. Un procédé comprenant
mettre un ou plusieurs partenaires de connexion sur un support (50), dans lequel chacun du un ou des plusieurs partenaires de connexion a un ou plusieurs deuxièmes partenaires de connexion, qui y sont disposés, et dans lequel une couche (30) de soudure est disposée entre chacun du un ou des plusieurs deuxièmes partenaires de connexion et le premier partenaire de connexion respectif,
le procédé étant **caractérisé par** :
mettre le support (50) ayant le un ou les plusieurs partenaires de connexion, qui y sont disposés, dans la chambre (400) de traitement de l'agencement suivant l'une quelconque des revendications 1 à 8,
insérer du gaz de traitement dans le tube (404) d'alimentation en remplissant ainsi la chambre (400) de traitement et la chambre (402) à inducteur de gaz de traitement, et
chauffer par induction le un ou les plusieurs premiers partenaires de connexion par la une ou les plusieurs couches (30) de soudure et les deuxièmes partenaires de connexion, qui y sont disposés, au moyen du un ou des plusieurs inducteurs (60).

10. Le procédé de la revendication 9, comprenant en outre
retirer le gaz de traitement de la chambre (400) de traitement et de la chambre (402) à inducteur par le tube (406) de sortie, et
retirer le support (50) de la chambre (400) de traitement.

11. Le procédé de la revendication 9 ou 10, dans lequel chauffer par induction le un ou les plusieurs premiers partenaires de connexion par la une ou les plusieurs couches (30) de soudure et les deuxièmes partenaires de connexion, qui y sont disposés, au moyen du un ou des plusieurs inducteurs (60), comprend appliquer un courant alternatif à chacun du un ou des plusieurs inducteurs (60) en créant ainsi un champ magnétique alternatif de support (50), étant disposés dans le champ magnétique alternatif.

12. Le procédé de la revendication 11, dans lequel le support (50) supporte au moins une plaque (52) métallique, et chauffé par induction le un ou les plusieurs premiers partenaires de connexion par la une ou les plusieurs couches (30) de soudure et des deuxièmes partenaires de connexion, qui y sont disposés, au moyen du au moins un ou plusieurs inducteurs (60), comprend en outre induire des courants électromagnétiques dans la une ou les plusieurs plaques (52) métalliques en chauffant ainsi la une ou les plusieurs plaques (52) métalliques.
